(19) Europäisches Patentamt
European Patent Office
Office européen des brevets

(11) **EP 1 363 296 B1**

(12) **EUROPÄISCHE PATENTSCHRIFT**

(45) Veröffentlichungstag und Bekanntmachung des Hinweises auf die Patenterteilung:
**12.08.2015 Patentblatt 2015/33**

(21) Anmeldenummer: **03010845.0**

(22) Anmeldetag: **14.05.2003**

(51) Int Cl.:
*H01F 17/00* (2006.01)     *H03H 1/00* (2006.01)
*H02M 1/12* (2006.01)     *H01F 38/10* (2006.01)
*H05B 41/28* (2006.01)

(54) **Funkentstörfilter**

Interference suppression filter

Filtre de suppression d'interférences

(84) Benannte Vertragsstaaten:
**AT BE BG CH CY CZ DE DK EE ES FI FR GB GR HU IE IT LI LU MC NL PT RO SE SI SK TR**

(30) Priorität: **15.05.2002 DE 10221631**

(43) Veröffentlichungstag der Anmeldung:
**19.11.2003 Patentblatt 2003/47**

(73) Patentinhaber: **Tridonic GmbH & Co KG**
**6851 Dornbirn (AT)**

(72) Erfinder: **Seibt, Marco**
**90425 Nürnberg (DE)**

(74) Vertreter: **Rupp, Christian et al**
**Mitscherlich PartmbB**
**Patent- und Rechtsanwälte**
**Postfach 33 06 09**
**80066 München (DE)**

(56) Entgegenhaltungen:
**EP-A1- 1 365 426      WO-A1-02/056322**
**JP-A- H03 215 917     US-A- 4 873 757**
**US-A- 5 420 558      US-A- 5 747 981**
**US-A- 5 777 277      US-A- 5 834 902**
**US-B1- 6 384 705**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung bezieht sich bevorzugt auf ein Elektronisches Vorschaltgerät (EVG) für eine Gasentladungslampe, das über ein Funkentstörfilter mit mindestens zwei strombegrenzenden Drosselspulen zur Funkentstörung verfügt.

Wie alle elektrischen und elektronischen Geräte müssen auch die Leuchten von Gasentladungslampen und ihre Betriebsgeräte die einschlägigen Vorschriften in Bezug auf Sicherheit und Elektromagnetische Verträglichkeit (EMV) beachten. Dies gilt insbesondere für die Verursachung von Funkstörungen, welche sowohl im Versorgungsnetz als auch in ihrer Umgebung eine Reihe von Störungen hervorrufen könnten. In diesem Zusammenhang sind vor allem diejenigen Funkstörungen zu nennen, die von den Start- und Zündgeräten der Gasentladungslampe sowie von der Lampe selbst ausgehen können. In der Regel lassen sich diese Funkstörungen durch entsprechend bemessene Entstörkondensatoren begrenzen. Die Betriebsgeräte und Leuchten müssen dabei je nach ihrer Verwendung bestimmten Mindestanforderungen bezüglich derstörung entsprechen und die entsprechenden Prüfzeichen tragen. Netzrückwirkungen durch Oberwellen müssen ebenfalls unterhalb der gesetzlich vorgeschriebenen Grenzwerte liegen.

Funkstörungen können sowohl von den Leitungen als auch von den Lampen selbst abgestrahlt werden. Jedoch ist dieser Anteil sehr klein und daher meist vernachlässigbar. Den überwiegenden Anteil an Funkstörungen bilden Störspannungen, die sich über die Netzzuleitungen im Netz ausbreiten. Diese Störspannungen können ihren Ursprung in den Betriebsgeräten haben - wie im Falle Elektronischer Vorschaltgeräte (EVG) - oder von den Lampen selbst ausgehen. Bei Konventionellen Vorschaltgeräten (KVG) sind es, mit Ausnahme der Zündgeräte, fast ausschließlich die Gasentladungslampen selbst, die zum Störspektrum beitragen.

Die Ursache dieser Störspannungen sind die Schwingungen der Ladungsträger im Plasma. Typische Störquellen sind zum Beispiel Anodenfallschwingungen, deren Oberwellen bis in den langwelligen Bereich (um 300 kHz) reichen können. Störspannungen bei höheren Frequenzen entstehen meist durch das Lösch- und Wiederzündrauschen. Eine intensive Funkstörquelle bilden auch die Brennfleckbewegungen von Hochdrucklampen. In diesem Fall können die Störungen sogar bis zu 100 MHz erreichen.

Von einer erdfreien Störquelle gehen zunächst nur Störungen aus, die sich längs der angeschlossenen Leitungen ausbreiten. Wie der Netzstrom fließt auch der Störstrom über eine erste Anschlussleitung zur Störsenke hin und über eine zweite Anschlussleitung wieder zurück zur Störquelle. Eine derartige Störung wird allgemein als "Gegentaktstörung" (engl.: "Differential Mode") oder symmetrische Störung bezeichnet.

Parasitäre Kapazitäten in der Störquelle oder beabsichtigte Masseverbindungen rufen jedoch auch einen Störstrom im Erdkreis hervor. Dieser Störstrom fließt auf beiden Anschlussleitungen von der Störquelle zur Störsenke und über Erdleitungen wieder zurück zur Störquelle. Eine solche Störung wird in der Fachliteratur auch "Gleichtaktstörung" (engl.: "Common Mode") oder asymmetrische Störung genannt.

In der europäischen Fachliteratur existiert ferner der Begriff der sogenannten "unsymmetrischen Störung", welche die Störspannung zwischen der ersten oder zweiten Anschlussleitung und der Bezugsmasse kennzeichnet.

Ziel einer jeden Entstörmaßnahme ist es, die Ausbreitung der in der Leuchte erzeugten Störströme ins Netz zu vermeiden.

Prinzipiell bietet sich in diesem Zusammenhang die Möglichkeit, den Störstrom entweder "abzublocken" oder ihn innerhalb der Leuchte "kurzzuschließen", um ein Abfließen des Störstroms zu einer Störsenke zu verhindern oder zumindest zu verringern. Eine Induktivität $L$ (also eine Spule mit oder ohne Eisenkern) stellt für den in der Regel hochfrequenten Störstrom einen großen induktiven Blindwiderstand $X_L$ dar, blockt ihn also ab; dem niederfrequenten Netzstrom setzt sie jedoch nur einen geringen induktiven Blindwiderstand entgegen. Im Gegensatz dazu ist eine Kapazität $C$ für den hochfrequenten Störstrom niederohmig, d.h. sie stellt dem Störstrom einen verhältnismäßig niedrigen kapazitiven Blindwiderstand $X_c$ entgegen und ermöglicht so das Kurzschließen des Störstroms; für den niederfrequenten Netzstrom ist eine Kapazität dagegen hochohmig.

Nachdem der Störstrom einer Leuchte, für die eine Entstörmaßnahme festgelegt werden soll, zuvor unter Laborbedingungen gemessen wurde, zeigt sich unter Umständen bereits im Vorfeld, dass die Leuchte bereits ohne besondere Zusatzmaßnahmen die gesetzlich vorgeschriebenen Grenzwerte einhält. Dies ist speziell bei geteilten Vorschaltgeräten der Fall, da durch die im Außenleiter und Mittelpunktsleiter geschalteten Induktivitäten der Störstrom bereits abgeblockt wird.

Werden die Grenzwerte nur knapp überschritten, kann eine optimierte Leitungsführung mit möglichst kurzen Leitungen, welche nahe am geerdeten Gehäuse verlaufen und möglichst keine Schleifen bilden sollten, zum Erreichen der geforderten Werte genügen. Werden die Grenzwerte jedoch nicht eingehalten, werden in der Regel spezielle Entstörkondensatoren eingesetzt. Der für diese Entstörmaßnahme notwendige Aufwand ergibt sich aus der Beantwortung der Frage, ob Entstörkondensatoren nur netzparallel oder netzparallel und gegen Erde geschaltet werden müssen und ist stark von der lampenseitigen parasitären Kapazität des Vorschaltgeräts abhängig. Je geringer diese Kapazität ist, desto geringer ist auch die Gleichtaktstörung, die nur durch gegen die Bezugsmasse geschaltete Kondensatoren abgebaut werden kann.

Die Entstörschaltung und die Werte der Bauteile müssen über Messreihen geeignet festgelegt werden. Hierbei ist zwischen X- und Y-Kondensatoren zu unterscheiden. X-Kondensatoren werden nur netzparallel eingesetzt, Y-Kondensatoren dürfen auch zwischen Außenleiter und Gehäuse eingesetzt werden. Bei der Auswahl der Kapazitätswerte von Y-Kondensatoren ist insbesondere darauf zu achten, dass der Ableitstrom gegen das Gehäuse für den Menschen nicht gefährlich ist.

Eine mit derartigen Entstörkondensatoren beschaltete Leuchte hält in der Regel die gesetzlich vorgeschriebenen Grenzwerte für die Messung der Einfügungsdämpfung mit großer Sicherheit ein. Falls dies nicht zutrifft - z.B. wenn der Innenwiderstand $R_i$ der Leuchte im Vergleich zum Betrag des komplexen Scheinwiderstands $\underline{Z}_c$ (Impedanz) des netzparallelen Entstörkondensators $C$ zu klein, oder aber die asymmetrischen Störströme zu groß sind -, muss auf komplexere Entstörfilter zurückgegriffen werden, die sowohl Induktivitäten als auch Kapazitäten enthalten.

Bei herkömmlichen Elektronischen Vorschaltgeräten (EVG) nach dem Stand der Technik ist es üblich, dem Gleichrichter ein Funkentstörfilter in Form einer strombegrenzenden Drossel vorzuschalten, welche aus zwei gleichartigen Flachspulen besteht, die gegensinnig gewickelt, miteinander induktiv gekoppelt und in beide Ein- bzw. Ausgangsleitungen geschaltet sind. Auf diese Weise ist dafür gesorgt, dass sich im Falle von Gleichtaktstörungen der durch je zwei solcher Wicklungen fließenden Lastströme die durch diese Wechselströme erzeugten magnetischen Felder gegenseitig kompensieren und somit der Eisenkern der Flachspulen nicht in Sättigung gefahren wird. Infolgedessen ist die Drossel für den normalen, gegenläufig orientierten Stromfluss unwirksam; Gleichtaktstörungen werden allerdings wirksam abgeblockt. Weil zudem auch keine Gleichstrom-Vormagnetisierung berücksichtigt werden muss, kann eine derartige zur Strombegrenzung eingesetzte Drosselspule sehr klein aufgebaut werden.

Im Allgemeinen kann eine Ausbreitung der Störungen ins Netz mit Hilfe von Strombegrenzungsdrosseln verhindert werden. Die höherfrequenten Anteile einer Funkstörung lassen sich durch parallelgeschaltete Kondensatoren auf ein zulässiges Maß reduzieren. Aus diesem Grund sind weitere Maßnahmen für eine zusätzliche Entstörung von Gasentladungslampen nur in den seltensten Fällen notwendig.

In Bezug auf die in den folgenden Abschnitten beschriebenen Funkentstördrosseln nach einem Ausführungsbeispiel der erfindungsgemäßen Lösung ist insbesondere die US-Patentschrift 4,873,757 von technischer Relevanz. Hierin ist von einer monolithisch integrierten Vielschicht-Induktivität eines SMD-Bauelements (engl.: "Surface-Mounted Device") die Rede, bei welcher ein auf ein Substrat aufgedrucktes Verdrahtungslayout mit je einer spiralförmigen Flachspule pro Schicht verwendet wird, wobei die Wicklungen der Flachspule der ersten Schicht parallel zu den Wicklungen der Flachspulen in den anderen Schichten angeordnet sind, mit diesen in Serie geschaltet und über elektrisch leitende Durchkontaktierungen miteinander galvanisch verbunden sind. Die in dieser Druckschrift beschriebenen Spulen werden dabei insbesondere in den Transformatoren von Energieversorgungseinrichtungen und Gleichspannungswandlerschaltungen eingesetzt.

JP-H-03215917 offenbart einen Funkentstörfilter gemäß Oberbegriff von Anspruch 12 und eine Verwendung von zwei strombegrenzenden Drosselspulen in einem Funkentstörfilter gemäß Oberbegriff von Anspruch 1.

PROBLEME HERKÖMMLICHER LÖSUNGEN NACH DEM STAND DER TECHNIK

Das grundlegende Problem herkömmlicher Funkentstördrosseln, die zur Kompensation asymmetrischer Stromkomponenten eingesetzt werden, besteht darin, dass die Unterdrückung dieser Gleichtaktstörungen, bedingt durch die jeweilige Spulengeometrie und die Anordnung der Spulen, nicht vollständig erfolgt. Im Folgenden soll dieses Problem am Beispiel zweier induktiv gekoppelter ineinandergreifender Flachspulen näher erläutert werden.

Der Selbstinduktionskoeffizient $L$ (also die Induktivität) einer Flachspule, deren geometrische Form durch eine archimedische Spirale gegeben ist, berechnet sich allgemein nach der folgenden Formel:

$$L = N^2 \cdot \Lambda \; [\mu\text{H}] \; \text{mit} \; \Lambda = \frac{1}{R_m} = \frac{\overline{R}^2}{25,4 \cdot \left(8 \cdot \overline{R} + 11 \cdot W\right)} \cdot \frac{\mu\text{H}}{\text{mm}},$$

wobei

$\Lambda \, [\mu\text{H}]$     der magnetische Leitwert (Permeanz) der Flachspule,

$N$     die Wicklungszahl der Flachspule,

$\overline{R}\,[\text{mm}]$     der mittlere Radius der Flachspule,

$R_m \, [\mu\text{H}^{-1}]$     der magnetische Widerstand (Reluktanz) der Flachspule und

$W \, [\text{mm}]$     die Breite der von den Wicklungen der Flachspule und den Zwischenräumen zwischen den einzelnen Wicklungen benötigten Fläche ist.

Werden die beiden ineinandergreifenden spiralförmigen Wicklungen zweier gleich- bzw. gegensinnig gewickelter, miteinander induktiv gekoppelter Flachspulen gleicher Windungszahl ($N_1 = N_2 =: N$) und Breite ($W_1 = W_2 =: W$) koplanar angeordnet, bedeutet dies, dass die besagten Flachspulen nicht dieselbe Induktivität haben können ($L_1 \neq L_2$),

da ihre mittleren Radien verschieden groß sind ($\overline{R}_1 \neq \overline{R}_2$); die Wicklung der einen Flachspule verläuft nämlich "innen", die der anderen "außen" (bezogen auf das Zentrum der Flachspule).

## AUFGABE DER VORLIEGENDEN ERFINDUNG

Ausgehend von dem oben genannten Stand der Technik, widmet sich die vorliegende Erfindung der Aufgabe, eine Spulenanordnung bereitzustellen, mit deren Hilfe die oben beschriebene Divergenz der Induktivitäten $L_1$ und $L_2$ zweier koplanar angeordneter, gegensinnig gewickelter und miteinander induktiv gekoppelter Flachspulen gleicher Windungszahl und Breite vermieden wird. Ihre Wicklungen sollen dabei dergestalt ausgebildet sein, dass sich die bei gegenläufig orientiertem Stromfluss durch die beiden Spulen $L_1$ und $L_2$ erzeugten magnetischen Felder bei Überlagerung gegenseitig kompensieren, Gleichtaktstörungen jedoch wirksam abgeblockt werden.

Diese Aufgabe wird erfindungsgemäß durch die Merkmale der unabhängigen Patentansprüche gelöst. Vorteilhafte Ausführungsbeispiele, die den Gedanken der Erfindung weiterbilden, sind in den abhängigen Patentansprüchen definiert.

## ZUSAMMENFASSENDE DARSTELLUNG DER VORLIEGENDEN ERFINDUNG

Der Gegenstand der zugrunde liegende Erfindung ist durch den Funkentstörfilter gemäß Anspruch 12 und die Verwendung von zwei strombegrenzenden Drosselspulen in einem Funkentstörer gemäß Anspruch 1 definiert.

## KURZBESCHREIBUNG DER ZEICHNUNGEN

Weitere bevorzugte Merkmale, Vorteile und Zweckmäßigkeiten der zugrunde liegenden Erfindung resultieren aus den untergeordneten abhängigen Patentansprüchen, welche nunmehr, bezugnehmend auf die Figuren der begleitenden Zeichnungen und anhand einer detaillierten Beschreibung eines Ausführungsbeispiels der zugrunde liegenden Erfindung, erläutert werden sollen. Hierbei zeigen:

Fig. 1 ein Funktionsschaltbild zur Veranschaulichung der Komponenten eines Elektronischen Vorschaltgeräts (EVG) für eine Gasentladungslampe,

Fig. 2a ein Prinzipschaltbild eines Filternetzwerks nach dem Stand der Technik für das Elektronische Vorschaltgerät (EVG) der Leuchte einer Gasentladungslampe zur Funkentstörung zwischen der Lampe und dem Netz,

Fig. 2b ein Ersatzschaltbild einer konventionellen Drosselspule mit Ferrit- oder Pulvereisenkern,

Fig. 2c ein Zeigerdiagramm für das Ersatzschaltbild der konventionellen Drosselspule mit Ferrit- oder Pulvereisenkern,

Fig. 3 die Wicklungen zweier gegensinnig gewickelter, spiralförmig ineinandergreifender Flachspulen der beiden induktiv gekoppelten Drosseln in einer ersten Schicht (der obersten Schicht) der erfindungsgemäßen dreidimensionalen Spulenanordnung,

Fig. 4 die Wicklungen zweier gegensinnig gewickelter, spiralförmig ineinandergreifender Flachspulen der beiden induktiv gekoppelten Drosseln in einer (direkt unterhalb der ersten Schicht gelegenen) zweiten Schicht der erfindungsgemäßen dreidimensionalen Spulenanordnung,

Fig. 5 die Wicklungen zweier gegensinnig gewickelter, spiralförmig ineinandergreifender Flachspulen der beiden induktiv gekoppelten Drosseln in einer (direkt unterhalb der zweiten Schicht gelegenen) dritten Schicht der erfindungsgemäßen dreidimensionalen Spulenanordnung,

Fig. 6 die Wicklungen zweier gegensinnig gewickelter, spiralförmig ineinandergreifender Flachspulen der beiden induktiv gekoppelten Drosseln in einer (direkt unterhalb der dritten Schicht gelegenen) vierten Schicht der erfindungsgemäßen dreidimensionalen Spulenanordnung,

Fig. 7 die Wicklungen zweier gegensinnig gewickelter, spiralförmig ineinandergreifender Flachspulen der beiden induktiv gekoppelten Drosseln in einer (direkt unterhalb der vierten Schicht gelegenen) fünften Schicht der erfindungsgemäßen dreidimensionalen Spulenanordnung,

Fig. 8      die Wicklungen zweier gegensinnig gewickelter, spiralförmig ineinandergreifender Flachspulen der beiden induktiv gekoppelten Drosseln in einer (direkt unterhalb der fünften Schicht gelegenen) sechsten Schicht der erfindungsgemäßen dreidimensionalen Spulenanordnung,

Fig. 9a      eine herkömmlichen Wicklungsanordnung, bei der die Wicklungen einer ersten Drosselspule $L_1$ in allen Schichten stets "außen" und die Wicklungen einer zweiten Drosselspule $L_2$ in allen Schichten stets "innen" - jeweils bezogen auf das Zentrum der beiden Flachspulen in einer Schicht - liegen,

Fig. 9b+c      zwei erfindungsgemäße Wicklungsanordnungen, mit Hilfe derer die Leckinduktivität des Spulensystems reduziert werden kann,

Fig. 10a-f      sechs Ausführungsbeispiele der erfindungsgemäßen Flachspulen, deren Wicklungen als rechteckig, achteckig bzw. ovalartig geformte Spiralen ausgebildet sind und dabei einen konstanten (Fig. 10a,c,e) bzw. in Richtung des'Spiralenzentrums verjüngten Leiterbahnquerschnitt aufweisen (Fig. 10b,d,f) .

## DETAILLIERTE BESCHREIBUNG DER ERFINDUNG

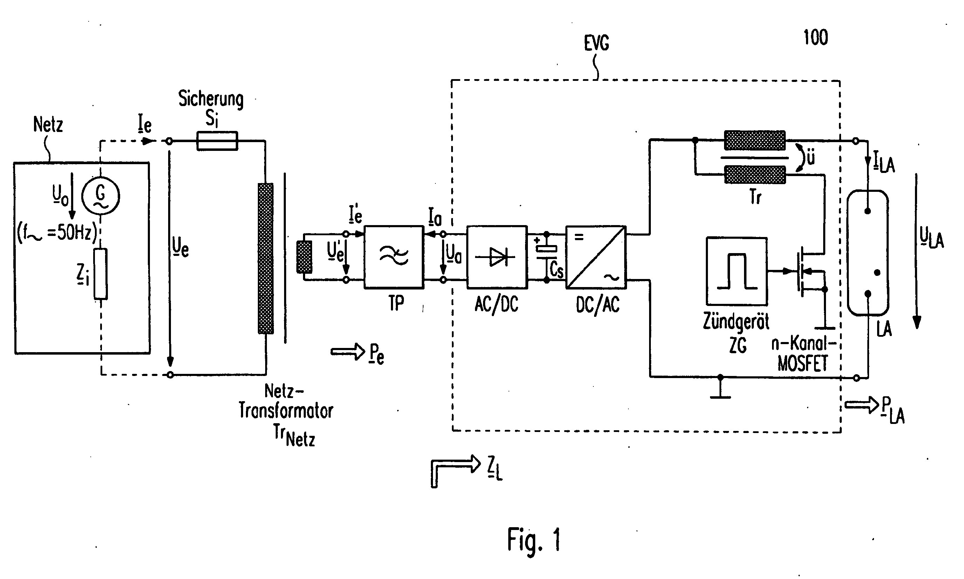

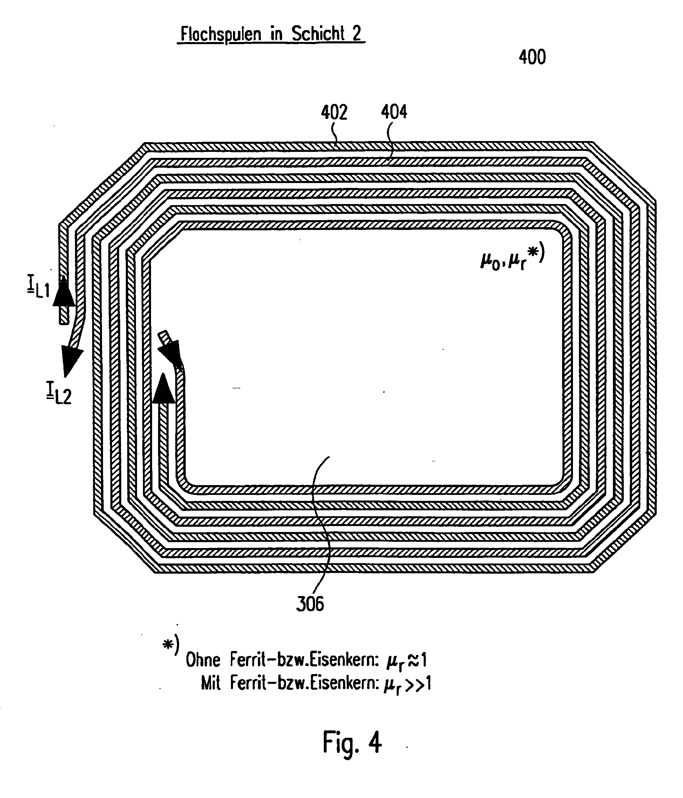

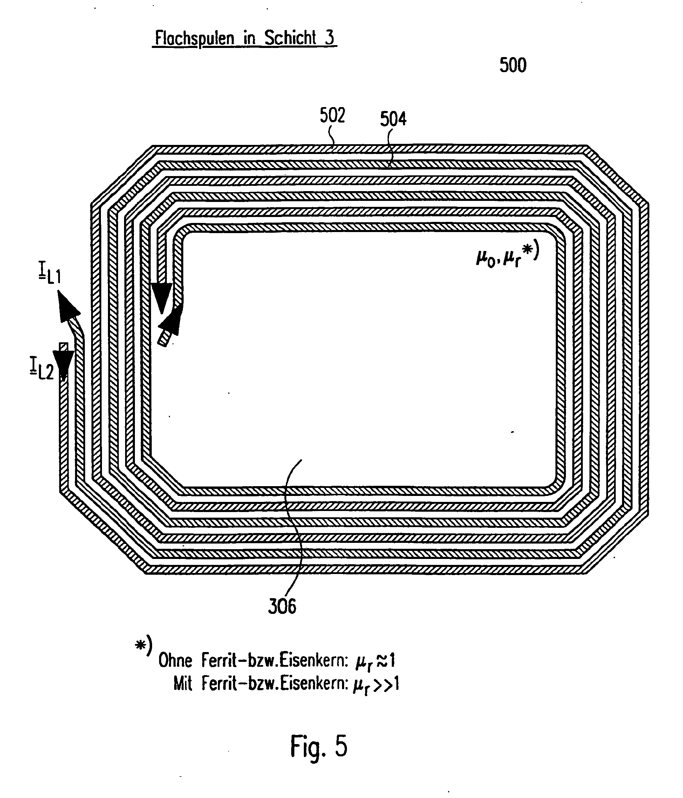

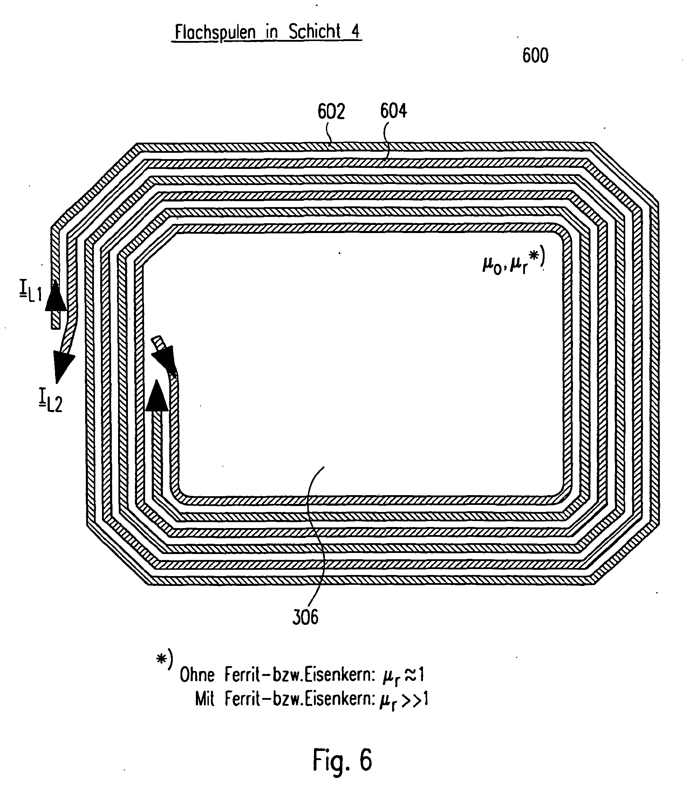

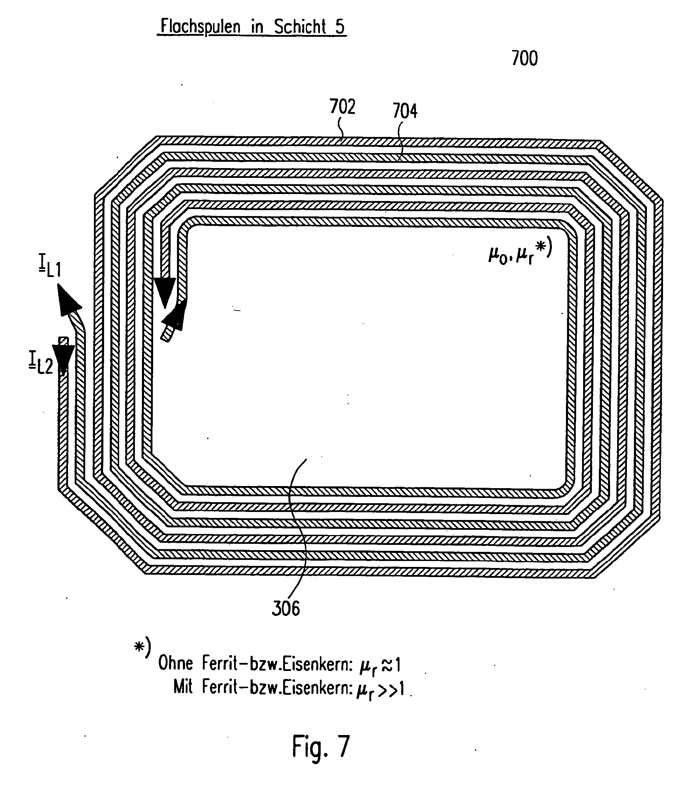

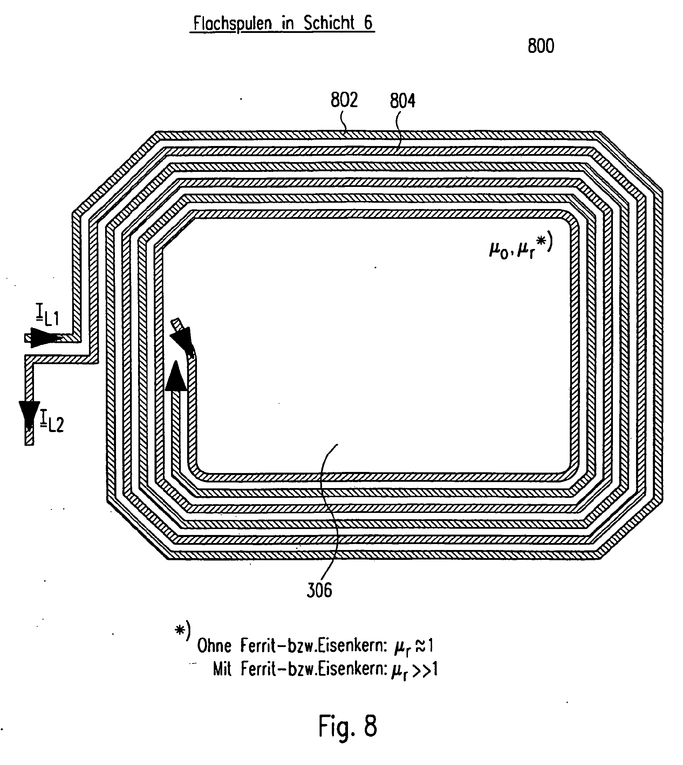

Im Folgenden werden die Funktionen der in den Ausführungsbeispielen der vorliegenden Erfindung enthaltenen Systemkomponenten und Baugruppen, wie in den Figuren 1 bis 10f abgebildet, näher beschrieben. Die Bedeutung der mit Bezugszeichen versehenen Symbole in den Figuren 1 bis 10f kann der beigefügten Bezugszeichenliste entnommen werden.

In Fig. 1 ist schematisch ein Funktionsschaltbild zur Veranschaulichung der Komponenten eines Elektronischen Vorschaltgeräts (EVG) für die Leuchte einer Gasentladungslampe LA dargestellt, welches über das erfindungsgemäße Funkentstörfilter TP zur Unterdrückung von Gleichtaktstörungen verfügt. Das Funkentstörfilter TP erfüllt dabei den Zweck, den Netzstrom $\underline{I}_e$ zu glätten, die auftretenden hochfrequenten Störströme $\underline{I}_{L1}$ und $\underline{I}_{L2}$ zu unterdrücken und die ins Netz eingeleitete Störspannung, welche durch Schaltvorgänge im EVG erzeugt wird, auf einen gesetzlich noch zulässigen Wert zu reduzieren.

In diesem Zusammenhang weist das erfindungsgemäße EVG unter anderem einen Wechselrichter DC/AC mit zwei in Serie geschalteten, an einer Gleichspannungsquelle $U_{bus}$ angeschlossenen und abwechselnd getakteten Leistungstransistoren $T_1$ und $T_2$ auf. Das Schalten kann dabei durch eine Steuereinheit erfolgen, die als integrierte Schaltung (IC), zum Beispiel in Form eines ASIC, realisiert werden kann. Auf diese Weise entnimmt der Wechselrichter DC/AC dem Gleichrichter AC/DC einen in Rechteckblöcke zerhackten Strom.

Als Gleichrichter AC/DC kann z.B. eine konventionelle Diodenhalbbrücke dienen. Falls der netzfrequeht modulierte Lampenstrom $\underline{I}_{LA}$ zur Begrenzung der Netzstromoberwellen genutzt wird, dürfen auf der Gleichspannungsseite keine großen Energiespeicher eingesetzt werden. Der Strom am Ausgangstor des Wechselrichters ist dann proportional zum aktuellen Betrag der Netzspannung $\underline{U}_e$. Die gesetzlichen Vorschriften zur Begrenzung der Netzstromoberwellen lassen sich damit auf einfache und elegante Weise einhalten.

Mit Hilfe eines Transformators Tr, der mit einem Eisenkern ausgestattet ist, können die mit Hilfe des Wechselrichters DC/AC gewonnenen hochfrequenten Zündimpulse zum Betrieb der Gasentladungslampe LA in den Zündkreis induktiv eingekoppelt werden.

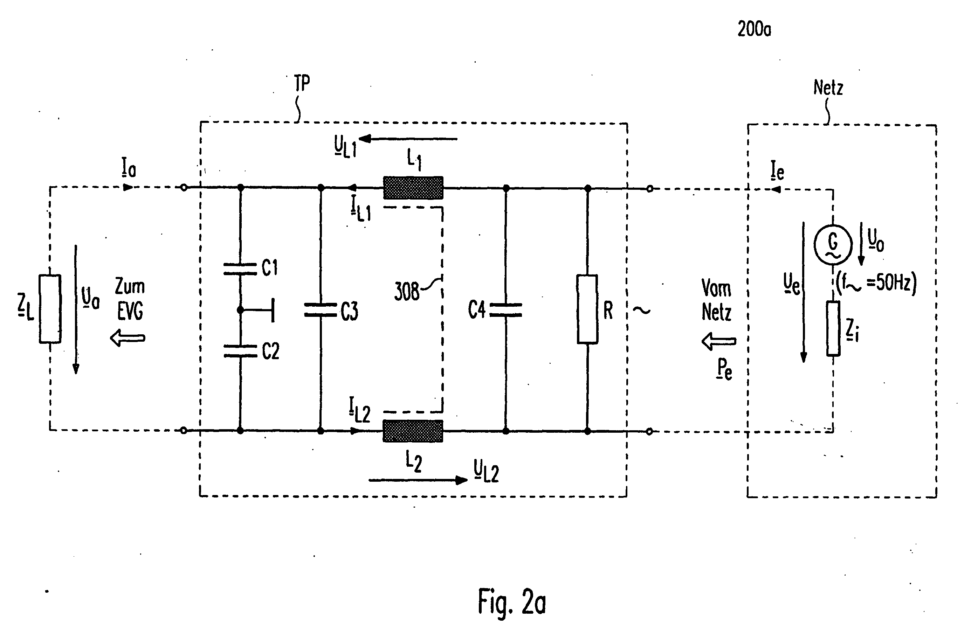

Fig. 2a zeigt ein Prinzipschaltbild eines üblicherweise eingesetzten Funkentstörfilters TP nach dem Stand der Technik für das Elektronische Vorschaltgerät (EVG) der Leuchte einer Gasentladungslampe LA zur Funkentstörung zwischen der Lampe und dem Netz. Dieses Filter TP kann vorteilhaft eingesetzt werden, um die von der Lampe LA erzeugten Störimpulse soweit abzuschwächen, dass bei deren Betrieb keine unzulässig hohen Störströme $\underline{I}_{L1}$ und $\underline{I}_{L2}$ fließen, die dann an die Umgebung, zum Beispiel über die Versorgungsleitungen des öffentlichen Netzes, abgegeben werden. Es wirkt dabei als Tiefpassfilter, welches hochfrequente Wechselströme blockiert und niederfrequente Wechselströme, wie beispielsweise den vom Netz gelieferten Strom $\underline{I}_e$, durchlässt. Bei der Lösung dieser Aufgabe sind große Kapazitäten $C_1$, $C_2$, $C_3$ und $C_4$ (X-Kondensatoren) zwischen den Netzklemmen nützlich, da sie in Verbindung mit den Filterinduktivitäten $L_1$ und $L_2$ preiswerte Tiefpassfilter bilden. Grundsätzlich werden derartige Entstörfilter TP immer dann eingesetzt, wenn konstruktive (also schaltungstechnische) Maßnahmen am störenden Gerät nicht zu einer wirksamen Unterdrückung der Störungen ausreichen.

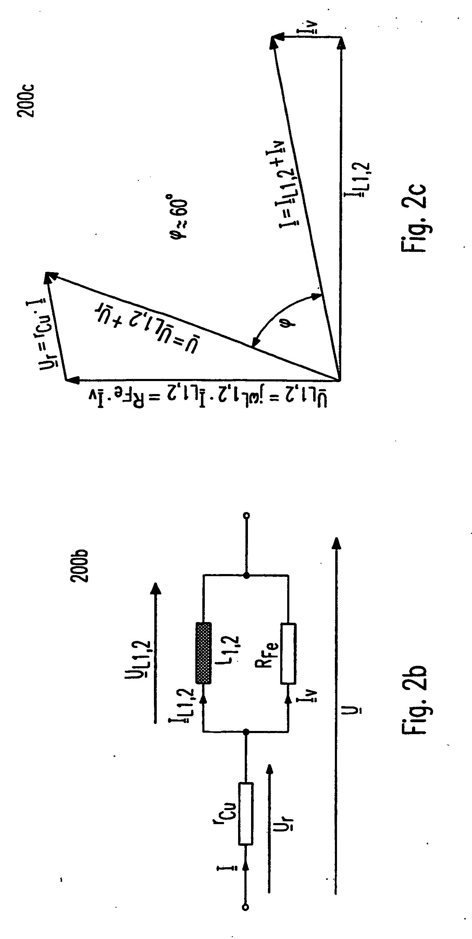

In diesem Zusammenhang ist anzumerken, dass nicht nur in den Wicklungen 302 bzw. 304 einer derartigen Drosselspule $L_1$ bzw. L$_2$ aufgrund von Wärmeentwicklung Leistungsverluste zu verzeichnen sind, sondern unabhängig davon auch in ihrem Kern 308 infolge der auftretenden Wirbelströme und Hysterese-Effekte. Fig. 2b zeigt ein Ersatzschaltbild einer konventionellen Drosselspule $L_1$ bzw. $L_2$ mit Ferrit- oder Pulvereisenkern 308, bei dem die Leistungsverluste im Kern 308 durch einen parallel zur Spule $L_1$ bzw. $L_2$ liegenden ohmschen Verlustwiderstand $R_{Fe}$ [$\Omega$] und die Leistungsverluste in den einzelnen Wicklungen 302 bzw. 304 durch einen ohmschen Verlustwiderstand $r_{CU}$ [$\Omega$] in Serie zu der oben genannten Parallelschaltung aus Drosselspule $L_1$ bzw. $L_2$ und Verlustwiderstand $R_{Fe}$ des Kerns 308 modelliert werden.

Aus dem zugehörigen Zeigerdiagramm in Fig. 2c wird ersichtlich, dass der Zeiger des durch die Drosselspule $L_1$ bzw. $L_2$ fließenden komplexen Gesamtstroms $\underline{I}$ [A] unter Berücksichtigung der oben genannten Leistungsverluste im Kern 308 sich als geometrische Summe aus den Zeigern des Spulenstroms $\underline{I}_{L1}$ bzw. $\underline{I}_{L2}$ und eines Verluststromanteils $\underline{I}_v$ ergibt, wobei der Strom $\underline{I}_{L1}$ bzw. $\underline{I}_{L2}$ als reiner Blindstrom der an der Spule $L_1$ bzw. $L_2$ abfallenden reinen Blindspannung $\underline{U}_{L1}$ bzw. $\underline{U}_{L2}$ um 90° nacheilt, während der Strom $\underline{I}_v$ als reiner Wirkstrom mit $\underline{U}_{L1}$ bzw. $\underline{U}_{L2}$ phasengleich ist. Die Stromkomponente $\underline{I}_{L1}$ bzw. $\underline{I}_{L2}$ wird hierbei auch als Magnetisierungsstrom bezeichnet und würde allein wirksam sein, wenn der Kern 308 als verlustlos angenommen werden könnte. Unter Berücksichtigung der oben genannten Leistungsverluste in den Wicklungen 302 bzw. 304 ergibt sich der Zeiger der an der Drosselspule $L_1$ bzw. $L_2$ abfallenden komplexen Gesamtspannung $\underline{U}$ [V] dann als geometrische Summe der beiden Spannungen $\underline{U}_r$ und $\underline{U}_{L1}$ bzw. $\underline{U}_{L2}$. Zur Konstruktion des Zeigers der Gesamtspannung U wird dabei der Zeiger des ohmschen Spannungsabfalls

$$\underline{U}_r = r_{Cu} \cdot \underline{I} \ [V]$$

parallel zum Zeiger des Gesamtstroms $\underline{I}$ an der Spitze des Zeigers der Blindspannung $\underline{U}_{L1}$ bzw. $\underline{U}_{L2}$ aufgetragen. Den Leistungsfaktor $cos(\varphi)$ findet man aus der Beziehung

$$cos(\varphi) = \frac{P_{v,Cu} + P_{v,Fe}}{P} \quad \text{mit} \quad P_{v,Cu} = |\underline{I}|^2 \cdot r_{Cu}, \quad P_{v,Fe} = \frac{|\underline{U}|^2}{R_{Fe}},$$

$$P_v = P_{v,Fe} + P_{v,Cu} = Re\left\{\underline{P}\right\} = Re\left\{\underline{U} \cdot \underline{I}^*\right\} \quad \text{und} \quad P := |\underline{P}| = \left|\underline{U} \cdot \underline{I}^*\right|,$$

wobei

$P_{v,Cu}$ [W]    die Wirkleistung des Leistungsverlusts durch die Kupferwicklungen 302 bzw. 304 bezeichnet,
$P_{v,Fe}$ [W]    die Wirkleistung des Leistungsverlusts durch den Ferrit- bzw. Pulvereisenkern 308,
$P_v$ [W]        die Summe der Wirkleistungen beider Leistungsverluste,
$P$ [VA]        den Absolutbetrag der Scheinleistungsaufnahme P der Drosselspule $L_1$ bzw. $L_2$ und
$\varphi$ [o]        den Phasenwinkel zwischen dem Zeiger der komplexen Gesamtspannung $\underline{U}$ und dem komplexen Gesamtstrom $\underline{I}$.

Wie aus Fig. 2c hervorgeht, ergibt sich dabei näherungsweise eine Phasenverschiebung $\varphi$ von 60°, was einem Leistungsfaktor $cos(\varphi)$ von 0,5 entspricht.

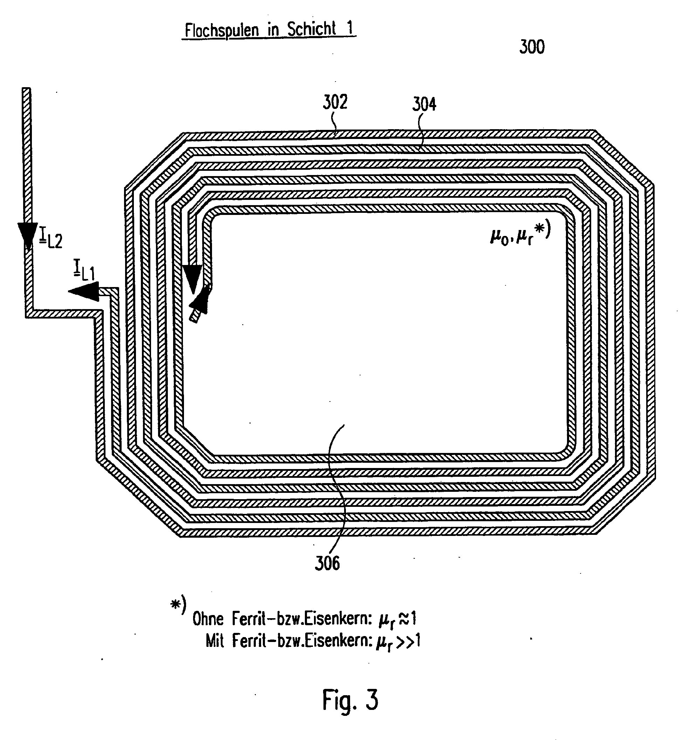

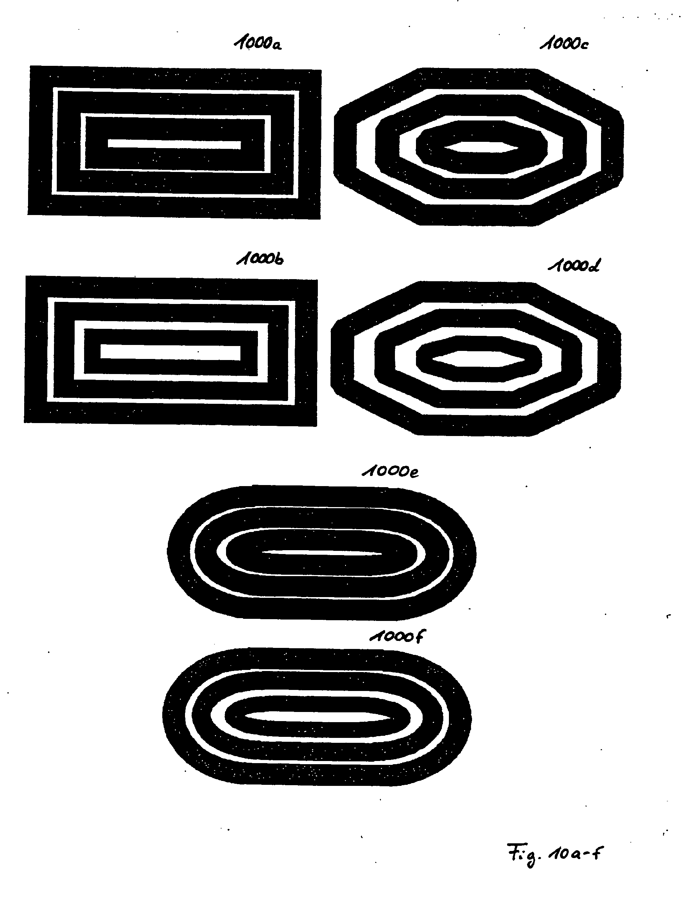

Nach einem Ausführungsbeispiel der zugrunde liegenden Erfindung, wie in den Figuren 3 bis 8 abgebildet, sind die Teile 302, 304, 402, 404, 502, 504, 602, 604, 702, 704 sowie 802 und 804 der Flachspulen der beiden Funkentstördrosseln $L_1$ und $L_2$ in einer Mehrlagentechnik mit $N$ Schichten planar angeordnet, wobei in jeder Schicht zwei gegensinnig gewickelte, spiralförmig ineinandergreifende Flachspulen rechteckiger, achteckiger bzw. ovaler Ausführungsform (s. Fig. 10a-f) miteinander induktiv gekoppelt sind. Erfindungsgemäß wird der Leiterbahnquerschnitt der einzelnen Wicklungen 302 und 304, 402 und 404, 502 und 504, 602 und 604, 702 und 704, 802 und 804 in Richtung des Zentrums der in der jeweiligen Schicht spiralförmig ineinandergreifenden Flachspulen schmäler und mit zunehmendem Abstand von diesem Zentrum breiter. Auf diese Weise wird eine platzsparende, flächige Gestaltung der Flachspulen ermöglicht, die über mehrere Schichten verteilt ist. Ferner wird mit Hilfe dieser Anordnung bewirkt, dass Gleichtaktstörungen von den Drosseln $L_1$ und $L_2$ wirksam abgeblockt werden können; für den normalen, gegenläufig orientierten Stromfluss der durch die beiden Drosseln $L_1$ und $L_2$ fließenden Ströme $\underline{I}_{L1}$ und $\underline{I}_{L2}$ bleibt das Filter TP jedoch unwirksam, da sich die orts- und zeitabhängigen magnetischen Felder $\vec{H}_1(\vec{x},t)$ und $\vec{H}_2(\vec{x},t)$ der beiden Wicklungen bei Überlagerung gegenseitig kompensieren:

$$\vec{H}_1(\vec{x},t) + \vec{H}_2(\vec{x},t) = \vec{0}.$$

Durch den Wechsel von der jeweils inneren zur äußeren Wicklung von einer Schicht zur nächsten wird ein streng symmetrischer Aufbau erreicht, wodurch eine homogene magnetische Feldverteilung und eine verbesserte Filterwirkung für symmetrische Stromkomponenten erzielt werden kann.

Die Mehrlagentechnik eröffnet die Möglichkeit, den oben genannten Nachteil unterschiedlicher Teilinduktivitäten der beiden Funkentstördrosseln $L_1$ und $L_2$ dadurch zu kompensieren, dass die zu realisierenden Drosseln in paarweise koplanar angeordnete, spiralförmig ineinandergreifende Flachspulen 302 und 304, 402 und 404, 502 und 504, 602 und 604, 702 und 704, 802 und 804 aufgeteilt werden, von denen jedes Paar in einer anderen Schicht angeordnet ist. In diesem Zusammenhang ist erfindungsgemäß vorgesehen, dass die Wicklungen 302 und 304, 402 und 404, 502 und 504, 602 und 604, 702 und 704, 802 und 804 der beiden Drosselspulen $L_1$ und $L_2$ zur gegenseitigen Kompensation der magnetischen Felder, die durch den Stromfluss durch die beiden Drosselspulen $L_1$ und $L_2$ erzeugt werden, in den Schichten 1 bis $N$ wie folgt angeordnet werden:

- symmetrisch zu einer senkrecht zu den Schichtebenen der einzelnen Flachspulen 302 und 304, 402 und 404, 502 und 504, 602 und 604, 702 und 704, 802 und 804 durch die Zentren dieser Flachspulen verlaufenden Längsachse (*y*-Achse) und

- symmetrisch zu einer parallel zu den Schichtebenen verlaufenden Ebene (*z-x*-Ebene), die im Falle einer Spulenanordnung mit einer geraden Schichtenanzahl $N$ per Definition in der Mitte zwischen den Schichtebenen $N/2$ und $N/2+1$ verläuft und im Falle einer Spulenanordnung mit einer ungeraden Schichtenanzahl N definitionsgemäß mit der Mittelebene von Schicht (N+1)/2 zusammenfällt.

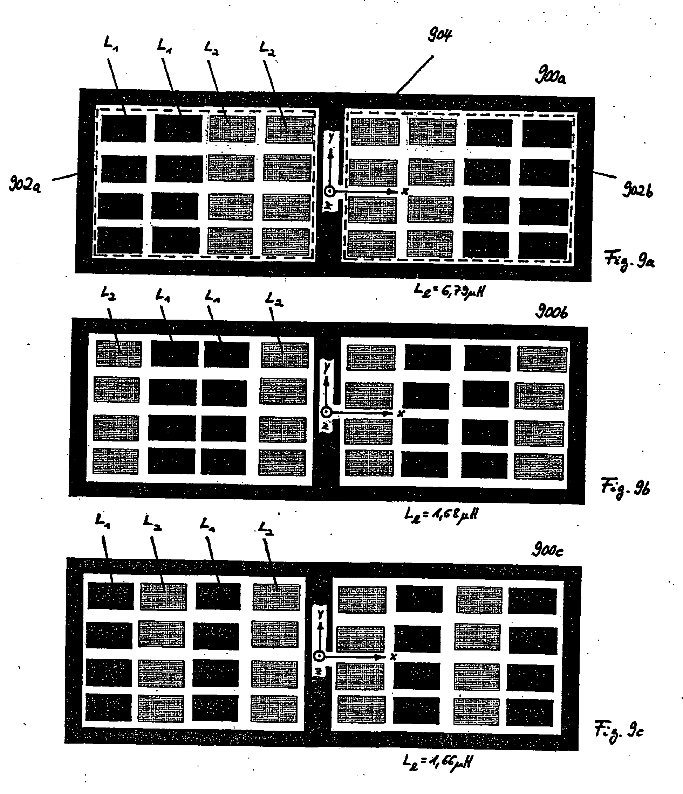

Bei den in Fig. 9a-c skizzierten Ausführungsformen sind beispielsweise Spulenanordnungen mit je 17 Schichten angegeben, wobei gemäß obiger Festlegung die *z-x*-Ebene mit der Mittelebene von Schicht 9 zusammenfällt. Wie anhand der angegebenen Induktivitätswerte zu erkennen ist, kann die Leckinduktivität $L_1$ bei Verwendung geeigneter Wicklungsanordnungen, wie in Fig. 9b und Fig. 9c skizziert, im Vergleich zu herkömmlichen Wicklungsanordnungen, bei der die Wicklungen der ersten Drosselspule $L_1$ in allen Schichten stets "außen" und die Wicklungen der zweiten Drosselspule $L_2$ in allen Schichten stets "innen" - jeweils bezogen auf das Zentrum der beiden Flachspulen in einer Schicht - liegen (vgl. Fig. 9a), um 75,3 % bzw. 75,6 % von 6,79 µH auf 1,68 µH bzw. auf 1,66 µH verringert werden.

Nach einem Ausführungsbeispiel der vorliegenden Erfindung werden hierbei unmittelbar übereinander angeordnete Leiterbahnen der Flachspulen angrenzender Schichten zur gegenseitigen Kompensation der magnetischen Felder, die durch den Stromfluss durch die beiden Drosselspulen $L_1$ und $L_2$ erzeugt werden, gegensinnig gewickelt, um bei ungestörtem Betrieb einen gegenläufig orientierten Stromfluss durch die Wicklungen angrenzender Schichten zu erreichen. Erfindungsgemäß ist insbesondere eine sechslagige Spulenanordnung ($N = 6$) vorgesehen, bei der die in verschiedenen Schichten angeordneten Abschnitte zweier Wicklungen wechselweise so platziert werden, dass die in den ungeradzahligen Schichten (Nr. 1, 3 und 5) liegenden "inneren" Wicklungen 304, 504 und 704 der ersten Drossel $L_1$ in den geradzahligen Schichten (Nr. 2, 4 und 6) als "äußere" Wicklungen 402, 602 bzw. 802 weitergeführt werden, während die in den ungeradzahligen Schichten liegenden "äußeren" Wicklungen 302, 502 und 702 der zweiten Drossel $L_2$ in der den geradzahligen Schichten als "innere" Wicklungen 404, 604 bzw. 804 fortgesetzt werden.

Die untereinander in verschiedenen Schichten liegenden, zusammengehörigen Wicklungen der Drosseln $L_1$ bzw. $L_2$ sind hierbei über Durchkontaktierungen, die durch jeweils eine Schicht hindurch gehen können, galvanisch miteinander verbunden. Auf diese Weise kann sichergestellt werden, dass die induktiv gekoppelten Wicklungen der Funkentstördrosseln $L_1$ bzw. $L_2$ denselben mittleren Radius und damit dieselbe Teilinduktivität haben, wodurch sich eine homogene Feldverteilung sowie eine verbesserte Filterwirkung für symmetrische Stromkomponenten ergibt.

**Patentansprüche**

1. Verwendung von zwei strombegrenzenden Drosselspulen ($C_1$, $C_2$) in einem Funkentstörfilter (TP) mit mindestens einem Entstörkondensator ($C_1$, $C_2$, $C_3$, $C_4$),

    • wobei die Wicklungen (302 und 304, 402 und 404, 502 und 504, 602 und 604, 702 und 704, 802 und 804) der beiden Drosselspulen ($C_1$, $C_2$) induktiv gekoppelt sind,
    • wobei es sich bei den Wicklungen (302 und 304, 402 und 404, 502 und 504, 602 und 604, 702 und 704, 802 und 804) der beiden zur Strombegrenzung eingesetzten Drosselspulen ($L_1$ und $L_2$) um eine aus N Lagen bestehende mehrlagige Spulenanordnung (300, 400, 500, 600, 700, 800) handelt, wobei die Wicklungen (302 und 304, 402 und 404, 502 und 504, 602 und 604, 702 und 704, 802 und 804) der Drosselspulen ($L_1$ und $L_2$) in jeder der N Lagen jeweils eine Flachspule aufweisen und in jeder der N Lagen die Flachspule der Wicklung der einen Drosselspule und die Flachspule der Wicklung der anderen Drosselspule in dergleichen Ebene spiralförmig ineinandergreifen **dadurch gekennzeichnet, dass**
• sich der Leiterbahnquerschnitt der einzelnen Wicklungen (302 und 304, 402 und 404, 502 und 504, 602 und 604, 702 und 704, 802 und 804) in Richtung des Zentrums der in der jeweiligen Schicht spiralförmig ineinandergreifenden Flachspulen verschmälert und sich der Leiterbahnquerschnitt dieser Wicklungen mit zunehmendem Abstand von dem Zentrum der jeweiligen Schicht verbreitert.

2. Verwendung von zwei strombegrenzenden Drosselspulen in einem Funkentstörfilter nach Anspruch 1, **dadurch gekennzeichnet, dass**

• die Wicklungen der jeweiligen Flachspulen (302 und 304, 402 und 404, 502 und 504, 602 und 604, 702 und 704, 802 und 804) in den einzelnen Schichten als rechteckig oder achteckig geformte Spiralen ausgebildet sind.

3. Verwendung von zwei strombegrenzenden Drosselspulen in einem Funkentstörfilter nach Anspruch 1, **dadurch gekennzeichnet, dass**

• die Wicklungen der jeweiligen Flachspulen (302 und 304, 402 und 404, 502 und 504, 602 und 604, 702 und 704, 802 und 804) in den einzelnen Schichten als ovalartig geformte Spiralen ausgebildet sind.

4. Verwendung von zwei strombegrenzenden Drosselspulen in einem Funkentstörfilter nach einem der Ansprüche 1 bis 3,
**dadurch gekennzeichnet, dass**

• die jeweiligen Flachspulen (302 und 304, 402 und 404, 502 und 504, 602 und 604, 702 und 704, 802 und 804) in einer Schicht gegensinnig gewickelt sind, um bei ungestörtem Betrieb einen gegenläufig orientierten Stromfluss durch die Wicklungen einer Schicht zu erreichen.

5. Verwendung von zwei strombegrenzenden Drosselspulen in einem Funkentstörfilter nach einem der Ansprüche 1 bis 4,
**dadurch gekennzeichnet, dass**

• die Wicklungen (302 und 304, 402 und 404, 502 und 504, 602 und 604, 702 und 704, 802 und 804) der beiden Drosselspulen ($L_1$ und $L_2$) zur gegenseitigen Kompensation der magnetischen Felder, die durch den Stromfluss durch die beiden Drosselspulen ($L_1$ und $L_2$) erzeugt werden, in den Schichten 1 bis N wie folgt angeordnet werden:

- symmetrisch zu einer senkrecht zu den Schichtebenen der einzelnen Flachspulen (302 und 304, 402 und 404, 502 und 504, 602 und 604, 702 und 704, 802 und 804) durch die Zentren der Flachspulen verlaufenden Längsachse (y-Achse) und
- symmetrisch zu einer parallel zu den einzelnen Schichtebenen verlaufenden Ebene (z-x-Ebene), die im Falle einer geraden Schichtenanzahl N in der Mitte zwischen den Schichtebenen N/2 und N/2+1 verläuft und im Falle einer ungeraden Schichtenanzahl N mit der Mittelebene von Schicht (N+1)/2 zusammenfällt.

6. Verwendung von zwei strombegrenzenden Drosselspulen in einem Funkentstörfilter nach einem der Ansprüche 1 bis 5,
**dadurch gekennzeichnet, dass**

• die Flachspulen (302 und 304, 402 und 404, 502 und 504, 602 und 604, 702 und 704, 802 und 804) zur gegenseitigen Kompensation der magnetischen Felder, die durch den Stromfluss durch die beiden Drosselspulen ($L_1$ und $L_2$) erzeugt werden, in den jeweiligen Schichten so angeordnet werden, dass

- die Wicklungen (304, 402, 504, 602, 704 bzw. 802) der ersten Drosselspule (L1) in den ungeradzahligen Schichten der N-lagigen Spulenanordnung "innen" und in den geradzahligen Schichten "außen" liegen und
- die Wicklungen (302, 404, 502, 604, 702 bzw. 804) der zweiten Drosselspule (L2) in den ungeradzahligen Schichten der N-lagigen Spulenanordnung "außen" und in den geradzahligen Schichten "innen" liegen, und

• "innen" und "außen" jeweils auf das Zentrum der jeweiligen Flachspulen (302 und 304, 402 und 404, 502 und 504, 602 und 604, 702 und 704, 802 und 804) in der gleichen Schicht bezogen sind.

**7.** Verwendung von zwei strombegrenzenden Drosselspulen in einem Funkentstörfilter nach einem der Ansprüche 1 bis 6,
**dadurch gekennzeichnet, dass**

• die spiralförmig ineinandergreifenden Flachspulen (302 und 304, 402 und 404, 502 und 504, 602 und 604, 702 und 704, 802 und 804) der beiden Drosselspulen ($L_1$ und $L_2$) gegensinnig gewickelt sind und paarweise koplanar in sechs Schichten übereinander angeordnet sind.

**8.** Verwendung von zwei strombegrenzenden Drosselspulen in einem Funkentstörfilter nach einem der Ansprüche 1 bis 7,
**dadurch gekennzeichnet, dass**

• die unmittelbar übereinander angeordneten Leiterbahnen der Flachspulen (302 und 304, 402 und 404, 502 und 504, 602 und 604, 702 und 704, 802 und 804) angrenzender Schichten zur gegenseitigen Kompensation der magnetischen Felder, die durch den Stromfluss durch die beiden Drosselspulen ($L_1$ und $L_2$) erzeugt werden, gegensinnig gewickelt sind, um bei ungestörtem Betrieb einen gegenläufig orientierten Stromfluss durch die Wicklungen angrenzender Schichten zu erreichen.

**9.** Verwendung von zwei strombegrenzenden Drosselspulen in einem Funkentstörfilter nach einem der Ansprüche 1 bis 8,
**dadurch gekennzeichnet, dass**

• sowohl die zu der ersten Drosselspule ($L_1$) gehörenden Wicklungen (304, 402, 504, 602, 704 und 802) als auch die zu der zweiten Drosselspule ($L_2$) gehörenden Wicklungen (302, 404, 502, 604, 702 und 804) der betreffenden Flachspulen in den einzelnen Schichten in Serie geschaltet und über elektrisch leitende Durchkontaktierungen galvanisch miteinander verbunden sind.

**10.** Verwendung von zwei strombegrenzenden Drosselspulen in einem Funkentstörfilter nach Anspruch 9,
**dadurch gekennzeichnet, dass**

• die Durchkontaktierungen, welche die galvanische Verbindung zwischen den Enden der jeweils zusammengehörenden Wicklungen der beiden Drosselspulen ($L_1$ bzw. $L_2$) bilden, durch jeweils eine Schicht hindurch gehen.

**11.** Verwendung von zwei strombegrenzenden Drosselspulen in einem Funkentstörfilter nach Anspruch 9,
**dadurch gekennzeichnet, dass**

• die Durchkontaktierungen, welche die galvanische Verbindung zwischen den Enden der jeweils zusammengehörenden Wicklungen der beiden Drosselspulen ($L_1$ bzw. $L_2$) bilden, durch mehr als eine Schicht hindurch gehen.

**12.** Funkentstörfilter (TP), aufweisend zwei Drosselspulen ($L_1$ und $L_2$) zur Strombegrenzung in dem Funkentstörfilter (TP), deren Wicklungen (302 und 304, 402 und 404, 502 und 504, 602 und 604, 702 und 704, 802 und 804) induktiv gekoppelt sind,

• wobei es sich bei den Wicklungen (302 und 304, 402 und 404, 502 und 504, 602 und 604, 702 und 704, 802 und 804) der beiden zur Strombegrenzung eingesetzten Drosselspulen ($L_1$ und $L_2$) um eine aus N Lagen bestehende mehrlagige Spulenanordnung handelt, wobei die Wicklungen der Drosselspulen in jeder der N Lagen jeweils eine Flachspule aufweisen und in jeder der N Lagen die Flachspule der Wicklung der einen Drosselspule und die Flachspule der Wicklung der anderen Drosselspule in der gleichen Ebene spiralförmig ineinandergreifen **dadurch gekennzeichnet, dass**
• sich der Leiterbahnquerschnitt der einzelnen Wicklungen (302 und 304, 402 und 404, 502 und 504, 602 und 604, 702 und 704, 802 und 804) in Richtung des Zentrums der in der jeweiligen Schicht spiralförmig ineinandergreifenden Flachspulen verschmälert und sich der Leiterbahnquerschnitt dieser Wicklungen mit zunehmendem Abstand von dem Zentrum der jeweiligen Schicht verbreitert.

**13.** Funkentstörfilter (TP) nach Anspruch 12,
**dadurch gekennzeichnet, dass**

- die Wicklungen der jeweiligen Flachspulen (302 und 304, 402 und 404, 502 und 504, 602 und 604, 702 und 704, 802 und 804) in den einzelnen Schichten als rechteckig oder achteckig geformte Spiralen ausgebildet sind.

**14.** Funkentstörfilter (TP) nach Anspruch 12,
**dadurch gekennzeichnet, dass**

- die Wicklungen der jeweiligen Flachspulen (302 und 304, 402 und 404, 502 und 504, 602 und 604, 702 und 704, 802 und 804) in den einzelnen Schichten als ovalartig geformte Spiralen ausgebildet sind.

**15.** Funkentstörfilter (TP) nach einem der Ansprüche 12 bis 14,
**dadurch gekennzeichnet, dass**

- die jeweiligen Flachspulen (302 und 304, 402 und 404, 502 und 504, 602 und 604, 702 und 704, 802 und 804) in einer Schicht gegensinnig gewickelt sind, um bei ungestörtem Betrieb einen gegenläufig orientierten Stromfluss durch die Wicklungen einer Schicht zu erreichen.

**16.** Funkentstörfilter (TP) nach einem der Ansprüche 12 bis 15,
**dadurch gekennzeichnet, dass**

- die Wicklungen (302 und 304, 402 und 404, 502 und 504, 602 und 604, 702 und 704, 802 und 804) der beiden Drosselspulen ($L_1$ und $L_2$) zur gegenseitigen Kompensation der magnetischen Felder, die durch den Stromfluss durch die beiden Drosselspulen ($L_1$ und $L_2$) erzeugt werden, in den Schichten 1 bis N wie folgt angeordnet werden:

  - symmetrisch zu einer senkrecht zu den Schichtebenen der einzelnen Flachspulen (302 und 304, 402 und 404, 502 und 504, 602 und 604, 702 und 704, 802 und 804) durch die Zentren der Flachspulen verlaufenden Längsachse (y-Achse) und
  - symmetrisch zu einer parallel zu den einzelnen Schichtebenen verlaufenden Ebene (z-x-Ebene), die im Falle einer geraden Schichtenanzahl N in der Mitte zwischen den Schichtebenen N/2 und N/2+1 verläuft und im Falle einer ungeraden Schichtenanzahl N mit der Mittelebene von Schicht (N+1)/2 zusammenfällt.

**17.** Funkentstörfilter (TP) nach einem der Ansprüche 12 bis 16,
**dadurch gekennzeichnet, dass**

- die Flachspulen (302 und 304, 402 und 404, 502 und 504, 602 und 604, 702 und 704, 802 und 804) zur gegenseitigen Kompensation der magnetischen Felder, die durch den Stromfluss durch die Drosselspulen ($L_1$ und $L_2$) erzeugt werden, in den jeweiligen Schichten so angeordnet werden, dass

  - die Wicklungen (304, 402, 504, 602, 704 bzw. 802) einer ersten Drosselspule (L1) in den ungeradzahligen Schichten der N-lagigen Spulenanordnung "innen" und in den geradzahligen Schichten "außen" liegen und

- die Wicklungen (302, 404, 502, 604, 702 bzw. 804) einer zweiten Drosselspule (L2) in den ungeradzahligen Schichten der N-lagigen Spulenanordnung "außen" und in den geradzahligen Schichten "innen" liegen, "innen" und "außen" jeweils auf das Zentrum der jeweiligen Flachspulen (302 und 304, 402 und 404, 502 und 504, 602 und 604, 702 und 704, 802 und 804) in der gleichen Schicht bezogen sind.

**18.** Funkentstörfilter (TP) nach einem der Ansprüche 12 bis 17,
**dadurch gekennzeichnet, dass**

- die spiralförmig ineinandergreifenden Flachspulen (302 und 304, 402 und 404, 502 und 504, 602 und 604, 702 und 704, 802 und 804) der Drosselspulen ($L_1$ und $L_2$) gegensinnig gewickelt sind und paarweise koplanar in sechs Schichten übereinander angeordnet sind.

**19.** Funkentstörfilter (TP) nach einem der Ansprüche 12 bis 18,
**dadurch gekennzeichnet, dass**

• die unmittelbar übereinander angeordneten Leiterbahnen der Flachspulen (302 und 304, 402 und 404, 502 und 504, 602 und 604, 702 und 704, 802 und 804) angrenzender Schichten zur gegenseitigen Kompensation der magnetischen Felder, die durch den Stromfluss durch die beiden Drosselspulen ($L_1$ und $L_2$) erzeugt werden, gegensinnig gewickelt sind, um bei ungestörtem Betrieb einen gegenläufig orientierten Stromfluss durch die Wicklungen angrenzender Schichten zu erreichen.

20. Funkentstörfilter (TP) nach einem der Ansprüche 12 bis 19,
**dadurch gekennzeichnet, dass**

• sowohl die zu einer ersten Drosselspule ($L_1$) gehörenden Wicklungen (304, 402, 504, 602, 704 und 802) als auch die zu einer zweiten Drosselspule ($L_2$) gehörenden Wicklungen (302, 404, 502, 604, 702 und 804) der betreffenden Flachspulen in den einzelnen Schichten in Serie geschaltet und über elektrisch leitende Durchkontaktierungen galvanisch miteinander verbunden sind.

21. Funkentstörfilter (TP) nach Anspruch 20,
**dadurch gekennzeichnet, dass**

• die Durchkontaktierungen, welche die galvanische Verbindung zwischen den Enden der jeweils zusammengehörenden Wicklungen der Drosselspulen ($L_1$ bzw. $L_2$) bilden, durch jeweils eine Schicht hindurch gehen.

22. Funkentstörfilter (TP) nach Anspruch 20,
**dadurch gekennzeichnet, dass**

• die Durchkontaktierungen, welche die galvanische Verbindung zwischen den Enden der jeweils zusammengehörenden Wicklungen der Drosselspulen ($L_1$ bzw. $L_2$) bilden, durch mehr als eine Schicht hindurch gehen.

23. Elektronisches Vorschaltgerät zur Zündung sowie zum Betrieb einer Gasentladungslampe (LA), aufweisend:

• eine Gleichrichterschaltung (AC/DC) zur Umwandlung eines von einer Wechselspannungsquelle (Netz) gelieferten Wechselstroms in einen pulsierenden Gleichstrom,
• eine Wechselrichterschaltung (DC/AC) mit Kurzschlussschutz zum Zerhacken des von der Gleichrichterschaltung gelieferten pulsierenden Gleichstroms in rechteckförmige Zündimpulse eines hochfrequenten Wechselstroms,
• mindestens einen Transformator (Tr) zur induktiven Einkopplung der von der Wechselrichterschaltung (DC/AC) gelieferten hochfrequenten Zündimpulse in einen Zündkreis der Gasentladungslampe (LA),
ferner aufweisend
• einen Funkentstörfilter (TP) zur Filterung von hochfrequenten Gleichtaktstörungen nach einem der Ansprüche 12 bis 22.

**Claims**

1. Use of two current-limiting choke coils ($L_1$, $L_2$) in a radio interference filter (TP) with at least an anti-interference capacitor ($C_1$, $C_2$, $C_3$, $C_4$),

- whereby the coils (302 and 304, 402 and 404, 502 and 504, 602 and 604, 702 and 704, 802 and 804) of the two choke coils ($L_1$, $L_2$) are inductively coupled,
- whereby the windings (302 and 304, 402 and 404, 502 and 504, 602 and 604, 702 and 704, 802 and 804) of the two choke coils ($L_1$ and $L_2$) used to limit the current consist of a multilayer coil assembly (300, 400, 500, 600, 700, 800) with N layers, whereby the windings (302 and 304, 402 and 404, 502 and 504, 602 and 604, 702 and 704, 802 and 804) of the choke coils ($L_1$ and $L_2$) each has a flat coil in each of the N layers, whereby the flat coil of the winding of one choke coil and the flat coil of the winding of the other choke coil in each of the N layers spirally intertwine in the same plane,

**characterised in that**

- the conductor path cross-section of the individual windings (302 and 304, 402 and 404, 502 and 504, 602 and 604, 702 and 704, 802 and 804) narrows in the direction of the centre of the spirally intertwined flat coils in the respective layer, while the conductor path cross-section of these coils broadens with increasing distance from the centre of the respective layer.

2. Use of two current-limiting choke coils in a radio interference filter according to claim 1, **characterised in that**

 - the windings of the respective flat coils (302 and 304, 402 and 404, 502 and 504, 602 and 604, 702 and 704, 802 and 804) are formed in the individual layers as rectangular or octagonal shaped spirals.

3. Use of two current-limiting choke coils in a radio interference filter according to claim 1, **characterised in that**

 - the windings of the respective flat coils (302 and 304, 402 and 404, 502 and 504, 602 and 604, 702 and 704, 802 and 804) are formed in the individual layers as oval-like shaped spirals.

4. Use of two current-limiting choke coils in a radio interference filter according to any one of claims 1 to 3, **characterised in that**

 - the respective flat coils (302 and 304, 402 and 404, 502 and 504, 602 and 604, 702 and 704, 802 and 804) are wound in opposite directions in a layer in order to obtain a counter-oriented current flow through the windings of the layers during undisturbed operation.

5. Use of two current-limiting choke coils in a radio interference filter according to any one of the claims 1 to 4, **characterized in that**

 - for mutual compensation of the magnetic fields produced by the current flow through the two choke coils ($L_1$ and $L_2$), the windings (302 and 304, 402 and 404, 502 and 504, 602 and 604, 702 and 704, 802 and 804) of the two choke coils ($L_1$ and $L_2$) are arranged in the layers 1 to N as follows:
 - symmetrical to a perpendicular to the layer planes of the individual flat coils (302 and 304, 402 and 404, 502 and 504, 602 and 604, 702 and 704, 802 and 804) and running through the centres of the longitudinal axis (y-axis) of the flat coils, and
 - symmetrical to a plane (zx plane) running in a direction parallel to the individual layer planes, which, in the event of an even number of layers N runs in the middle between the layer planes N/2 and N/2+1, while in the event of an odd number of layers N, it coincides with the centre plane of layer (N + I)/2.

6. Use of two current-limiting choke coils in a radio interference filter according to any one of the claims 1 to 5, **characterized in that**

 - for mutual compensation of the magnetic fields produced by the current flow produced by the two choke coils ($L_1$ and $L_2$), the flat coils (302 and 304, 402 and 404, 502 and 504, 602 and 604, 702 and 704, 802 and 804) are arranged in the respective layers so that
 - the windings (304, 402, 504, 602, 704 or 802) of the first choke coil (L1) lie "inside" in the odd-numbered layers of the N-layer coil assembly, and "outside" in the even-numbered layers, and
 - the windings (302, 404, 502, 604, 702 or 804) of the second choke coil (L2) lie "outside" in the odd-numbered layers of the N-layer coil assembly, and lie "inside" in the even-numbered layers, and
 - "inside" and "outside" refer respectively to the centre of the respective flat coils (302 and 304, 402 and 404, 502 and 504, 602 and 604, 702 and 704, 802 and 804) in the same layer.

7. Use of two current-limiting choke coils in a radio interference filter according to one of the claims 1 to 6, **characterised in that**

 - the counter-wound spirally intertwined flat coils (302 and 304, 402 and 404, 502 and 504, 602 and 604, 702 and 704, 802 and 804) of the two choke coils ($L_1$ and $L_2$) are arranged in coplanar pairs above one another in six layers.

8. Use of two current-limiting choke coils in a radio interference filter according to any one of claims 1 to 7, **characterised in that**

- for the mutual compensation of the magnetic fields produced by the current flow through the two choke coils ($L_1$ and $L_2$), the directly superimposed conductor paths of the flat coils (302 and 304, 402 and 404, 502 and 504, 602 and 604, 702 and 704, 802 and 804) of adjacent layers are wound in opposite directions in order to achieve a counter-oriented current flow through the windings of adjacent layers during undisturbed operation.

9. Use of two current-limiting choke coils in a radio interference filter according to any one of the claims 1 to 8, **characterised in that**

- both the windings (304, 402, 504, 602, 704 and 802) associated with the first choke coil ($L_1$) as well as the windings (302, 404, 502, 604, 702 and 804) associated with the second choke coil ($L_2$) of the respective flat coils are connected in series in the individual layers and are galvanically connected to each other via electrically conductive vias.

10. Use of two current-limiting choke coils in a radio interference filter according to claim 9, **characterised in that**

- the vias that form the galvanic connection between the ends of each associated windings of the two choke coils ($L_1$ or $L_2$) each pass through one layer.

11. Use of two current-limiting choke coils in a radio interference filter according to claim 9, **characterised in that**

- the vias, which form the galvanic connection between the ends of each two associated windings of the choke coils ($L_1$ or $L_2$), pass through more than one layer.

12. Radio interference filter (TP) comprising two choke coils $L_1$ and $L_2$) and whose windings (302 and 304, 402 and 404, 502 and 504, 602 and 604, 702 and 704, 802 and 804) are inductively coupled together for current limiting in the radio interference filter (TP)

- whereby the windings (302 and 304, 402 and 404, 502 and 504, 602 and 604, 702 and 704, 802 and 804) of the two choke coils ($L_1$ and $L_2$) used for current limiting, consist of a multilayer coil arrangement having N layers, whereby the flat coil of the winding of one choke coil and the flat coil of the winding of the other choke coil in each of the N layers spirally intertwine in the same plane

**characterised in that**

- the conductor path cross-section of the individual windings (302 and 304, 402 and 404, 502 and 504, 602 and 604, 702 and 704, 802 and 804) narrows in the direction of the centre of the spirally intertwined flat coils in the respective layer, while the conductor path cross-section of these coils broadens with increasing distance from the centre of the respective layer.

13. Radio interference filter (TP) according to claim 12, **characterised in that**

- the windings of the respective flat coils (302 and 304, 402 and 404, 502 and 504, 602 and 604, 702 and 704, 802 and 804) are formed in the individual layers as rectangular or octagonal shaped spirals.

14. Radio interference filter (TP) according to claim 12, **characterised in that**

- the windings of the respective flat coils (302 and 304, 402 and 404, 502 and 504, 602 and 604, 702 and 704, 802 and 804) are formed in the individual layers as oval-like shaped spirals.

15. Radio interference filter (TP) according to any one of the claims 12 to 14, **characterised in that**

- the respective flat coils (302 and 304, 402 and 404, 502 and 504, 602 and 604, 702 and 704, 802 and 804) are wound in opposite directions in a layer in order to obtain a counter-oriented current flow through the windings of a layer during undisturbed operation.

**16.** Radio interference filter (TP) according to any one of the claims 12 to 15,
**characterised in that**

- for mutual compensation of the magnetic fields produced by the current flow through the two choke coils ($L_1$ and $L_2$), the windings (302 and 304, 402 and 404, 502 and 504, 602 and 604, 702 and 704, 802 and 804) of the two choke coils ($L_1$ and $L_2$) are arranged in the layers 1 to N as follows:
- symmetrical to a perpendicular to the layer planes of the individual flat coils (302 and 304, 402 and 404, 502 and 504, 602 and 604, 702 and 704, 802 and 804) and running through the centres of the longitudinal axis (y-axis) of the flat coils, and
- symmetrical to a plane (zx plane) running in a direction parallel to the individual layer planes, which, in the event of an even number of layers N runs in the middle between the layer planes N/2 and N/2+1, while in the event of an odd number of layers N, it coincides with the centre plane of layer (N + 1)/2.

**17.** Radio interference filter (TP) according to any one of the claims 12 to 16,
**characterised in that**

- for mutual compensation of the magnetic fields produced by the current flow produced by the two choke coils ($L_1$ and $L_2$), the flat coils (302 and 304, 402 and 404, 502 and 504, 602 and 604, 702 and 704, 802 and 804) are arranged in the respective layers so that
- the windings (304, 402, 504, 602, 704 or 802) of the first choke coil (L1) lie "inside" in the odd-numbered layers of the N-layer coil assembly, and "outside" in the even-numbered layers, and
- the windings (302, 404, 502, 604, 702 or 804) of the second choke coil (L2) lie "outside" in the odd-numbered layers of the N-layer coil assembly, and lie "inside" in the even-numbered layers, "inside" and "outside" refer respectively to the centre of the respective flat coils (302 and 304, 402 and 404, 502 and 504, 602 and 604, 702 and 704, 802 and 804) in the same layer.

**18.** Radio interference filter (TP) according to any one of the claims 12 to 17,
**characterised in that**

- the counter-wound spirally intertwined flat coils (302 and 304, 402 and 404, 502 and 504, 602 and 604, 702 and 704, 802 and 804) of the two choke coils ($L_1$ and $L_2$) are arranged in coplanar pairs above one another in six layers.

**19.** Radio interference filter (TP) according to any one of the claims 12 to 18,
**characterised in that**

- for the mutual compensation of the magnetic fields produced by the current flow through the two choke coils ($L_1$ and $L_2$), the directly superimposed conductor paths of the flat coils (302 and 304, 402 and 404, 502 and 504, 602 and 604, 702 and 704, 802 and 804) of adjacent layers are wound in opposite directions in order to achieve a counter-oriented current flow through the windings of adjacent layers during undisturbed operation.

**20.** Radio interference filter (TP) according to any one of the claims 12 to 19,
**characterised in that**

- both the windings (304, 402, 504, 602, 704 and 802) associated with the first choke coil ($L_1$) as well as the windings (302, 404, 502, 604, 702 and 804) associated with the second choke coil ($L_2$) of the respective flat coils are connected in series in the individual layers and are galvanically connected to each other via electrically conductive vias.

**21.** Radio interference filter (TP) according to claim 20,
**characterised in that**

- the vias that form the galvanic connection between the ends of each associated windings of the two choke coils ($L_1$ or $L_2$) each pass through one layer.

**22.** Radio interference filter (TP) according to claim 20,
**characterised in that**

- the vias, which form the galvanic connection between the ends of each two associated windings of the choke coils ($L_1$ or $L_2$), pass through more than one layer.

23. Electronic ballast for igniting and operating a gas discharge lamp (LA), comprising:

- a rectifier circuit (AC/DC) for converting an alternating current supplied from an AC power source (AC) to direct current,
- an inverter circuit (DC/AC), with short-circuit protection to chop the pulsating direct current supplied in a pulsating rectifier circuit into rectangular ignition pulses of a high frequency alternating current,
- at least a transformer (Tr) for the inductive coupling of the inverter circuit (DC/AC) of the supplied high frequency ignition pulses in an ignition circuit of the gas discharge lamp (LA), further comprising
- a radio interference filter (TP) for filtering high-frequency common-mode interference according to the claims 12 to 22.

**Revendications**

1. Utilisation de deux bobines d'inductance limitant le courant ($L_1$, $L_2$) dans un filtre antiparasite (TP) avec au moins un condensateur d'antiparasitage ($C_1$, $C_2$, $C_3$, $C_4$),

- les enroulements (302 et 304, 402 et 404, 502 et 504, 602 604, 702 et 704, 802 et 804) des deux bobines d'inductance ($L_1$, $L_2$) étant couplés par induction,
- les enroulements (302 et 304, 402 et 404, 502 et 504, 602 604, 702 et 704, 802 et 804) des deux bobines d'inductance ($L_1$, $L_2$) utilisées pour la limitation du courant étant un agencement de bobines (300, 400, 500, 600, 700, 800) multicouche constitué de N couches, les enroulements (302 et 304, 402 et 404, 502 et 504, 602 et 604, 702 et 704, 802 et 804) des bobines d'inductance ($L_1$, $L_2$) présentant respectivement dans chacune des N couches une bobine plate, et la bobine plate de l'enroulement d'une bobine d'inductance et la bobine plate de l'enroulement de l'autre bobine d'inductance s'engageant l'une dans l'autre dans un même plan en forme de spirale dans chacune des N couches,

**caractérisée en ce que** la section de la piste conductrice des différents enroulements (302 et 304, 402 et 404, 502 et 504, 602 et 604, 702 et 704, 802 et 804) se rétrécit dans la direction du centre des bobines plates s'engageant l'une dans l'autre en forme de spirale dans la couche correspondante et la section de la piste conductrice de ces enroulements s'élargit à mesure de l'augmentation de la distance par rapport au centre de la couche correspondante.

2. Utilisation de deux bobines d'inductance limitant le courant dans un filtre antiparasite selon la revendication 1, **caractérisée**
**en ce que** les enroulements des bobines plates respectives (302 et 304, 402 et 404, 502 et 504, 602 et 604, 702 et 704, 802 et 804) sont réalisés dans les différentes couches en tant que spirales de forme rectangulaire ou octogonale.

3. Utilisation de deux bobines d'inductance limitant le courant dans un filtre antiparasite selon la revendication 1, **caractérisée**
**en ce que** les enroulements des bobines plates respectives (302 et 304, 402 et 404, 502 et 504, 602 et 604, 702 et 704, 802 et 804) sont réalisés dans les différentes couches en tant que spirales de forme similaire à un ovale.

4. Utilisation de deux bobines d'inductance limitant le courant dans un filtre antiparasite selon l'une des revendications 1 à 3,
**caractérisée**
**en ce que** les bobines plates respectives (302 et 304, 402 et 404, 502 et 504, 602 et 604, 702 et 704, 802 et 804) sont enroulées en sens contraire dans une couche de façon à obtenir un flux de courant orienté en sens opposé à travers les enroulements d'une couche lorsque le fonctionnement n'est pas perturbé.

5. Utilisation de deux bobines d'inductance limitant le courant dans un filtre antiparasite selon l'une des revendications 1 à 4,
**caractérisée**
**en ce que** les enroulements (302 et 304, 402 et 404, 502 et 504, 602 et 604, 702 et 704, 802 et 804) des deux bobines d'inductance ($L_1$ et $L_2$) sont agencés de la manière suivante dans les couches 1 à N afin de réaliser une compensation réciproque des champs magnétiques qui sont créés par le flux de courant à travers les deux bobines d'inductance ($L_1$ et $L_2$) :

- symétriquement par rapport à un axe longitudinal (axe y) s'étendant perpendiculairement aux plans des couches des différentes bobines plates (302 et 304, 402 et 404, 502 et 504, 602 et 604, 702 et 704, 802 et 804) à travers les centres des bobines plates, et
- symétriquement par rapport à un plan s'étendant parallèlement aux différents plans des couches (axe z-x) qui, dans le cas d'un nombre de couches N pair, s'étend au milieu entre les plans des couches N/2 et N/2+1 et, dans le cas d'un nombre de couches N impair, coïncide avec le plan médian de la couche (N+1)/2.

6. Utilisation de deux bobines d'inductance limitant le courant dans un filtre antiparasite selon l'une des revendications 1 à 5,
**caractérisée**
**en ce que** les bobines plates (302 et 304, 402 et 404, 502 et 504, 602 et 604, 702 et 704, 802 et 804) sont agencées dans les couches respectives afin de réaliser une compensation réciproque des champs magnétiques qui sont créés par le flux de courant à travers les deux bobines d'inductance ($L_1$ et $L_2$) de telle sorte que :

- les enroulements (304, 402, 504, 602, 704 et 802) de la première bobine d'inductance (L1) se situent « à l'intérieur » dans les couches impaires de l'agencement de bobines à N couches et « à l'extérieur » dans les couches paires, et
- les enroulements (302, 404, 502, 604, 702 et 804) de la deuxième bobine d'inductance (L2) se situent « à l'extérieur » dans les couches impaires de l'agencement de bobines à N couches et « à l'intérieur » dans les couches paires, et en ce que les positions « à l'intérieur » et « à l'extérieur » font respectivement référence au centre des bobines plates correspondantes (302 et 304, 402 et 404, 502 et 504, 602 et 604, 702 et 704, 802 et 804) dans la même couche.

7. Utilisation de deux bobines d'inductance limitant le courant dans un filtre antiparasite selon l'une des revendications 1 à 6,
**caractérisée**
**en ce que** les bobines plates s'engageant l'une dans l'autre en forme de spirale (302 et 304, 402 et 404, 502 et 504, 602 et 604, 702 et 704, 802 et 804) des deux bobines d'inductance ($L_1$ et $L_2$) sont enroulées en sens contraire et sont agencées l'une au-dessus de l'autre par paire de façon coplanaire dans six couches.

8. Utilisation de deux bobines d'inductance limitant le courant dans un filtre antiparasite selon l'une des revendications 1 à 7,
**caractérisée**
**en ce que** les pistes conductrices agencées directement l'une au-dessus de l'autre des bobines plates (302 et 304, 402 et 404, 502 et 504, 602 et 604, 702 et 704, 802 et 804) de couches adjacentes sont enroulées en sens contraire afin de réaliser une compensation réciproque des champs magnétiques qui sont créés par le flux de courant à travers les deux bobines d'inductance ($L_1$ et $L_2$) de façon à obtenir un flux de courant orienté en sens opposé à travers les enroulements de couches adjacentes lorsque le fonctionnement n'est pas perturbé.

9. Utilisation de deux bobines d'inductance limitant le courant dans un filtre antiparasite selon l'une des revendications 1 à 8,
**caractérisée**
**en ce qu'**à la fois les enroulements (304, 402, 504, 602, 704 et 802) appartenant à la première bobine d'inductance ($L_1$) et les enroulements (302, 404, 502, 604, 702 et 804) appartenant à la deuxième bobine d'inductance ($L_2$) des bobines plates correspondantes sont montés en série dans les couches individuelles et raccordés l'un à l'autre par galvanisation par le biais de connexions transversales conductrices électriquement.

10. Utilisation de deux bobines d'inductance limitant le courant dans un filtre antiparasite selon la revendication 9,
**caractérisée**
**en ce que** les connexions transversales qui forment le raccordement galvanique entre les extrémités des enroulements correspondant respectivement les uns aux autres des deux bobines d'inductance ($L_1$ et $L_2$) traversent à chaque fois une couche.

11. Utilisation de deux bobines d'inductance limitant le courant dans un filtre antiparasite selon la revendication 9,
**caractérisée**

**en ce que** les connexions transversales qui forment le raccordement galvanique entre les extrémités des enroulements correspondant respectivement les uns aux autres des deux bobines d'inductance (L₁ et L₂) traversent plus d'une couche.

**12.** Filtre antiparasite (TP) présentant deux bobines d'inductance ($L_1$ et $L_2$) destinées à limiter le courant dans le filtre antiparasite (TP), dont les enroulements (302 et 304, 402 et 404, 502 et 504, 602 et 604, 702 et 704, 802 et 804) sont couplés par induction,
les enroulements (302 et 304, 402 et 404, 502 et 504, 602 et 604, 702 et 704, 802 et 804) des deux bobines d'inductance ($L_1$ et $L_2$) utilisées pour la limitation du courant étant un agencement de bobines multicouche constitué de N couches, les enroulements des bobines d'inductance présentant respectivement dans chacune des N couches une bobine plate, et la bobine plate de l'enroulement d'une bobine d'inductance et la bobine plate de l'enroulement de l'autre bobine d'inductance s'engageant l'une dans l'autre dans un même plan en forme de spirale dans chacune des N couches,
**caractérisé en ce que** la section de la piste conductrice des différents enroulements (302 et 304, 402 et 404, 502 et 504, 602 et 604, 702 et 704, 802 et 804) se rétrécit dans la direction du centre des bobines plates s'engageant l'une dans l'autre en forme de spirale dans la couche correspondante et la section de la piste conductrice de ces enroulements s'élargit à mesure de l'augmentation de la distance par rapport au centre de la couche correspondante.

**13.** Filtre antiparasite (TP) selon la revendication 12,
**caractérisé**
**en ce que** les enroulements des bobines plates respectives (302 et 304, 402 et 404, 502 et 504, 602 et 604, 702 et 704, 802 et 804) sont réalisés dans les différentes couches en tant que spirales de forme rectangulaire ou octogonale.

**14.** Filtre antiparasite (TP) selon la revendication 12,
**caractérisé**
**en ce que** les enroulements des bobines plates respectives (302 et 304, 402 et 404, 502 et 504, 602 et 604, 702 et 704, 802 et 804) sont réalisés dans les différentes couches en tant que spirales de forme similaire à un ovale.

**15.** Filtre antiparasite (TP) selon l'une des revendications 12 à 14,
**caractérisé**
**en ce que** les bobines plates respectives (302 et 304, 402 et 404, 502 et 504, 602 et 604, 702 et 704, 802 et 804) sont enroulées en sens contraire dans une couche de façon à obtenir un flux de courant orienté en sens opposé à travers les enroulements d'une couche lorsque le fonctionnement n'est pas perturbé.

**16.** Filtre antiparasite (TP) selon l'une des revendications 12 à 15,
**caractérisé**
**en ce que** les enroulements (302 et 304, 402 et 404, 502 et 504, 602 et 604, 702 et 704, 802 et 804) des deux bobines d'inductance ($L_1$ et $L_2$) sont agencés de la manière suivante dans les couches 1 à N afin de réaliser une compensation réciproque des champs magnétiques qui sont créés par le flux de courant à travers les deux bobines d'inductance ($L_1$ et $L_2$) :

- symétriquement par rapport à un axe longitudinal (axe y) s'étendant perpendiculairement aux plans des couches des différentes bobines plates (302 et 304, 402 et 404, 502 et 504, 602 et 604, 702 et 704, 802 et 804) à travers les centres des bobines plates, et
- symétriquement par rapport à un plan s'étendant parallèlement aux différents plans des couches (axe z-x) qui, dans le cas d'un nombre de couches N pair, s'étend au milieu entre les plans des couches N/2 et N/2+1 et, dans le cas d'un nombre de couches N impair, coïncide avec le plan médian de la couche (N+1)/2.

**17.** Filtre antiparasite (TP) selon l'une des revendications 12 à 16,
**caractérisé**
**en ce que** les bobines plates (302 et 304, 402 et 404, 502 et 504, 602 et 604, 702 et 704, 802 et 804) sont agencées dans les couches respectives afin de réaliser une compensation réciproque des champs magnétiques qui sont créés par le flux de courant à travers les deux bobines d'inductance ($L_1$ et $L_2$) de telle sorte que :

- les enroulements (304, 402, 504, 602, 704 et 802) d'une première bobine d'inductance (L1) se situent «à l'intérieur » dans les couches impaires de l'agencement de bobines à N couches et « à l'extérieur » dans les couches paires, et en ce que les enroulements (302, 404, 502, 604, 702 et 804) d'une deuxième bobine d'inductance (L2) se situent « à l'extérieur » dans les couches impaires de l'agencement de bobines à N couches et « à l'intérieur » dans les couches paires, les positions « à l'intérieur » et « à l'extérieur » faisant respectivement référence au centre des bobines plates correspondantes (302 et 304, 402 et 404, 502 et 504, 602 et 604, 702 et 704, 802 et 804) dans la même couche.

18. Filtre antiparasite (TP) selon l'une des revendications 12 à 17,
**caractérisé**
**en ce que** les bobines plates s'engageant l'une dans l'autre en forme de spirale (302 et 304, 402 et 404, 502 et 504, 602 et 604, 702 et 704, 802 et 804) des deux bobines d'inductance ($L_1$ et $L_2$) sont enroulées en sens contraire et sont agencées l'une au-dessus de l'autre par paire de façon coplanaire dans six couches.

19. Filtre antiparasite (TP) selon l'une des revendications 12 à 18,
**caractérisé**
**en ce que** les pistes conductrices agencées directement l'une au-dessus de l'autre des bobines plates (302 et 304, 402 et 404, 502 et 504, 602 et 604, 702 et 704, 802 et 804) de couches adjacentes sont enroulées en sens contraire afin de réaliser une compensation réciproque des champs magnétiques qui sont créés par le flux de courant à travers les deux bobines d'inductance ($L_1$ et $L_2$) de façon à obtenir un flux de courant orienté en sens opposé à travers les enroulements de couches adjacentes lorsque le fonctionnement n'est pas perturbé.

20. Filtre antiparasite (TP) selon l'une des revendications 12 à 19,
**caractérisé**
**en ce qu'**à la fois les enroulements (304, 402, 504, 602, 704 et 802) appartenant à la première bobine d'inductance ($L_1$) et les enroulements (302, 404, 502, 604, 702 et 804) appartenant à la deuxième bobine d'inductance ($L_2$) des bobines plates correspondantes sont montés en série dans les couches individuelles et raccordés l'un à l'autre par galvanisation par le biais de connexions transversales conductrices électriquement.

21. Filtre antiparasite (TP) selon la revendication 20,
**caractérisé**
**en ce que** les connexions transversales qui forment le raccordement galvanique entre les extrémités des enroulements correspondant respectivement les uns aux autres des bobines d'inductance ($L_1$ et $L_2$) traversent à chaque fois une couche.

22. Filtre antiparasite (TP) selon la revendication 20,
**caractérisé**
**en ce que** les connexions transversales qui forment le raccordement galvanique entre les extrémités des enroulements correspondant respectivement les uns aux autres des bobines d'inductance ($L_1$ et $L_2$) traversent plus d'une couche.

23. Ballast électronique destiné à allumer et à faire fonctionner une lampe à décharge à gaz (LA), présentant :

- un circuit redresseur (AC/DC) destiné à convertir un courant alternatif fourni par une source de tension alternative (réseau) dans un courant continu par impulsion,
- un circuit onduleur (DC/AC) avec une protection contre les courts-circuits destiné à hacher le courant continu par impulsion fourni par le circuit redresseur dans des impulsions d'allumage de forme rectangulaire d'un courant alternatif à haute fréquence,
- au moins un transformateur (Tr) destiné à coupler par induction les impulsions d'allumage à haute fréquence fournies par le circuit onduleur (DC/AC) dans un circuit d'allumage de la lampe à décharge à gaz (LA),

présentant en outre :

- un filtre antiparasite (TP) destiné à filtrer des bruitages en mode commun à haute fréquence selon l'une des revendications 12 à 22.

Fig. 1

Fig. 2a

EP 1 363 296 B1

200b

$\underline{U}_{L1,2}$

$\underline{I}_{L1,2}$

$L_{1,2}$

$\underline{I}$   $r_{Cu}$

$R_{Fe}$

$\underline{U}_r$

$\underline{I}_v$

$\underline{U}$

**Fig. 2b**

200c

$\underline{U}_r = r_{Cu} \cdot \underline{I}$

$\underline{U} = \underline{U}_{L1,2} + \underline{U}_r$

$\underline{U}_{L1,2} = j\omega L_{1,2} \cdot \underline{I}_{L1,2} = R_{Fe} \cdot \underline{I}_v$

$\varphi \approx 60°$

$\underline{I} = \underline{I}_{L1,2} + \underline{I}_v$

$\varphi$

$\underline{I}_v$

$\underline{I}_{L1,2}$

**Fig. 2c**

Flachspulen in Schicht 1

300

302    304

$\underline{I}_{L2}$

$\underline{I}_{L1}$

$\mu_0 \cdot \mu_r \,^{*)}$

306

$^{*)}$ Ohne Ferrit-bzw.Eisenkern: $\mu_r \approx 1$
Mit Ferrit-bzw.Eisenkern: $\mu_r \gg 1$

Fig. 3

Flachspulen in Schicht 2

400

402  404

$\mu_0, \mu_r$*)

$\underline{I}_{L1}$

$\underline{I}_{L2}$

306

*) Ohne Ferrit-bzw.Eisenkern: $\mu_r \approx 1$
Mit Ferrit-bzw.Eisenkern: $\mu_r \gg 1$

Fig. 4

Flachspulen in Schicht 3

500

502     504

$\mu_0, \mu_r$ *)

$\underline{I}_{L1}$

$\underline{I}_{L2}$

306

*) Ohne Ferrit-bzw.Eisenkern: $\mu_r \approx 1$
   Mit Ferrit-bzw.Eisenkern: $\mu_r \gg 1$

Fig. 5

Flachspulen in Schicht 4

600

602    604

$\mu_0, \mu_r$*)

$\underline{I}_{L1}$

$\underline{I}_{L2}$

306

*) Ohne Ferrit−bzw.Eisenkern: $\mu_r \approx 1$
   Mit Ferrit−bzw.Eisenkern: $\mu_r \gg 1$

Fig. 6

## Flachspulen in Schicht 5

700

702  704

$\mu_0, \mu_r$ *)

$I_{L1}$

$I_{L2}$

306

*) Ohne Ferrit-bzw.Eisenkern: $\mu_r \approx 1$
   Mit Ferrit-bzw.Eisenkern: $\mu_r \gg 1$

Fig. 7

Flachspulen in Schicht 6

800

802    804

$\mu_0, \mu_r$*)

$\underline{I}_{L1}$

$\underline{I}_{L2}$

306

*) Ohne Ferrit–bzw.Eisenkern: $\mu_r \approx 1$
Mit Ferrit–bzw.Eisenkern: $\mu_r \gg 1$

Fig. 8

Fig. 9a

Fig. 9b

Fig. 9c

1000a

1000c

1000b

1000d

1000e

1000f

Fig. 10a-f

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4873757 A
- JP H03215917 B